# EUROPEAN PATENT APPLICATION

(11) **EP 3 620 894 A1**
(43) Date of publication of application: **11.03.2020**
(21) Application number: 18192507.4
(22) Date of filing: 04.09.2018
(51) Int. Cl.: G06F 3/01

(54) **HAPTIC INTERFACE, PATTERNED LAYER STRUCTURE FOR A HAPTIC INTERFACE, AND METHOD FOR PRODUCING THE SAME**

(71) Applicant: Robert Bosch GmbH, 70442 Stuttgart (DE)
(72) Inventor: Jeon, Jin Han, 558962 Singapore (SG); Fook, Tony, 751589 Singapore (SG); Sagar, Kaushal, 787082 Singapore (SG); So, Yong Heng, 564596 Singapore (SG)

(57) **Abstract**

A method for producing a patterned layer structure for a haptic interface is provided, including: providing a substrate including a protection cover layer; providing cut lines in the protection cover layer forming a first patterned area and a second patterned area; removing the first patterned area from the protection cover layer; depositing a bottom electrode layer on the substrate and on the protection cover layer; removing the second patterned area from the protection cover layer, thereby patterning the bottom electrode layer providing a bottom electrode layer pattern; depositing an electroactive layer on the substrate and on the bottom electrode layer; providing a top electrode layer including a top electrode layer pattern, which may further include a top electrical contact portion. A patterned layer structure is also be provided. A haptic interface including the patterned layer structure is also provided.

## Description

### TECHNICAL FIELD

The present disclosure relates to a method for producing a patterned layer structure for a haptic interface. The present invention further relates to a patterned layer structure for a haptic interface, and to a haptic interface.

### BACKGROUND

There is an increasing trend of haptic applications for touch display interfaces such as consumer electronics. Haptic feedback recreates a tactile sensation in a user interface device by delivering either mechanical forces, pressures or vibrations to convey information to a user. In particular haptic actuator is the main component of a haptic system that provides mechanical actuation to deliver haptic perception for enhanced user experiences.

Todays' smart phones, touch pads and touchscreen display are mostly featured with vibrational haptic feedback driven by inertia-type actuators such as Eccentric Rotating Mass (ERM) and Linear Resonant Actuator (LRA). These actuators provide only whole device vibration and have several limitations particularly of bulky size, lack of realistic feedback and complex mechanical design.

Therefore, there is a need to provide for improved haptic actuators.

### SUMMARY

According to various embodiments, a method for producing a patterned layer structure for a haptic interface is provided. The method may include the step of providing a substrate and a protection cover layer disposed on the substrate. The method may further include the step of providing cut lines in the protection cover layer, thereby forming a first patterned area, a second patterned area, and optionally a remaining area of the protection cover layer. The method may further include the step of removing the first patterned area of the protection cover layer so as to expose a first portion of the substrate. The method may further include the step of depositing a bottom electrode layer on the exposed first portion of the substrate and on the second patterned area of the protection cover layer. The method may further include the step of removing the second patterned area of the protection cover layer and the bottom electrode layer on the second patterned area so as to expose a second portion of the substrate, thereby patterning the bottom electrode layer so as to form a bottom electrode layer pattern, which may include a bottom electrical contact portion. The method may further include the step of depositing an electroactive layer on the exposed second portion of the substrate and on the patterned bottom electrode layer. The method may further include the step of providing a top electrode layer including a top electrode layer pattern, which may further include a top electrical contact portion.

According to various embodiments, a patterned layer structure may be provided. The patterned layer structure may be produced by the method in accordance to various embodiments. According to various embodiments, a haptic interface may be provided including the patterned layer structure.

### BRIEF DESCRIPTION OF THE DRAWINGS

In the following description, various embodiments of the present disclosure are described with reference to the following drawings, in which:
FIG.1 shows a flow chart of a method 100, for producing a patterned layer structure, in accordance to various embodiments;
FIG. 2A shows a flow chart of a method for providing a top electrode layer, in accordance to some embodiments;
FIG. 2B shows a flow chart of a method for providing a top electrode layer, in accordance to some embodiments;
FIG. 3A shows a flow chart of a method 100, for producing a patterned layer structure, in accordance to various embodiments, wherein the top electrode layer may be provided according to method 140.1 or 140.2;
FIG. 3B shows a flow chart of a method 101, for producing a patterned layer structure including n additional electroactive layers and n additional electrode layers, in accordance to various embodiments;
FIG. 4 shows a schematic cross sectional view of the patterned layer structure during the various method steps, in accordance to various embodiments;
FIG. 5 shows a schematic top view of the patterned layer structure during the various method steps, in accordance to various embodiments;
FIG. 6A shows a transmittance spectrum taken of a patterned layer structure 605 as schematically shown in the inset and according to various embodiments;
FIG. 6B shows a line drawing representation of photograph taken of the patterned layer structure 605 against a white background 650 on which the letters "SCH" are printed in a dark color.
FIG. 7 shows a schematic cross sectional view of a patterned layer structure including n additional electroactive layers and n additional electrode layers, in accordance to various embodiments;
FIG. 8 shows a schematic top view of the patterned layer structure including n additional electroactive layers and n additional electrode layers, during the various method steps, in accordance to various embodiments;
FIG. 9 shows a schematic top view of a patterned layer structure wherein top strips 920 are in orthogonal arrangement in relation to bottom strips 910.

### DETAILED DESCRIPTION

The following detailed description describes specific details and embodiments in which the invention may be practiced. These embodiments are described in sufficient detail to enable those skilled in the art to practice the invention. Other embodiments may be utilized and changes may be made without departing from the scope of the invention. The various embodiments are not necessarily mutually exclusive, as some embodiments can be combined with one or more other embodiments to form new embodiments.

Features that are described in the context of an embodiment may correspondingly be applicable to the same or similar features in the other embodiments. Features that are described in the context of an embodiment may correspondingly be applicable to the other embodiments, even if not explicitly described in these other embodiments. Furthermore, additions and/or combinations and/or alternatives as described for a feature in the context of an embodiment may correspondingly be applicable to the same or similar feature in the other embodiments.

The reference numerals may be used to refer to identical or similar features across the drawings and/or embodiments and/or examples, the reference numerals in the 100's may refer to method and method steps, and the reference numerals in the 200's, 500's, 600's and 900's may refer to structural features.

The invention illustratively described herein may suitably be practiced in the absence of any element or elements, limitation or limitations, not specifically disclosed herein. Thus, for example, the terms "comprising", "including," containing", etc. shall be read expansively and without limitation. The word "comprise" or variations such as "comprises" or "comprising" will accordingly be understood to imply the inclusion of a stated integer or groups of integers but not the exclusion of any other integer or group of integers. Additionally, the terms and expressions employed herein have been used as terms of description and not of limitation, and there is no intention in the use of such terms and expressions of excluding any equivalents of the features shown and described or portions thereof, but it is recognized that various modifications are possible within the scope of the invention claimed. Thus, it should be understood that although the present invention has been specifically disclosed by exemplary embodiments and optional features, modification and variation of the inventions embodied herein disclosed may be resorted to by those skilled in the art, and that such modifications and variations are considered to be within the scope of this invention.

The expression "at least one of' followed by a list of items, includes any and all combinations of one or more of the associated listed items.

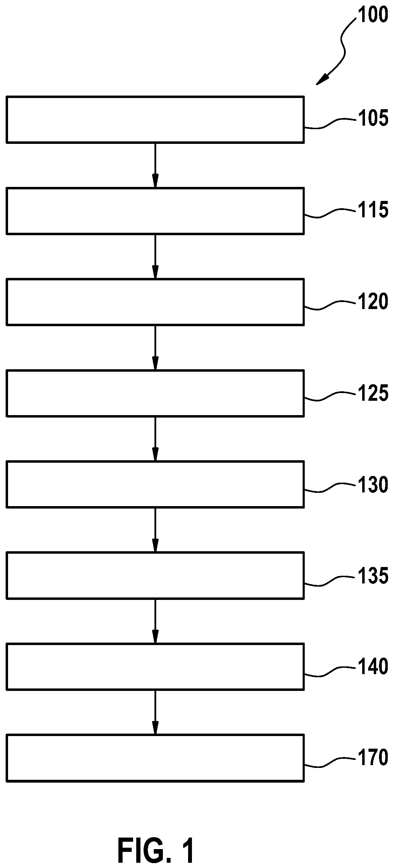

FIG.1 shows a flow chart of a method 100, for producing a patterned layer structure, in accordance to various embodiments. The method 100 may include the step 105 of providing a substrate. The substrate may include a protection cover layer. For example, the method 100 may include the step (not shown) of providing a protection cover layer on the substrate. The method 100 may further include the step 115 of providing cut lines in the protection cover layer forming a first patterned area and a second patterned area. The method 100 may further include the step 120 of removing the protection cover layer from the first patterned area, thus exposing the substrate at the first patterned area. The method 100 may further include the step 125 of depositing a bottom electrode layer on the substrate and on the protection cover layer. The method 100 may further include the step 130 of removing the protection cover layer from the second patterned area, thereby patterning the bottom electrode layer providing a bottom electrode layer pattern, which may further include a bottom electrical contact portion. The method 100 may further include the step 135 of depositing an electroactive layer on the substrate and on the bottom electrode layer. The method 100 may further include the step 140 of providing a top electrode layer including a top electrode layer pattern, which may further include a top electrical contact portion. The method 100 may further include the step 170 of removing a remaining portion of the protection cover layer from the substrate.

The present disclosure concerns a cost efficient and facile method for producing a patterned layer structure for haptic interface applications. According to various embodiments, the expression "haptic interface" may mean haptic feedback interface. The patterned layer structure may include at least an actuator including an electroactive layer which between and in electrical contact with a bottom electrode layer and a top electrode layer. The electroactive layer may include a ferroelectric polymer (FerroEAP), for example the FerroEAP may be the main electroactive polymer.

The method according to various embodiments may include coating process(es) and laser patterning process(es).

The actuators of the patterned layer structures produced in accordance to various embodiments demonstrate perceivable vibrational characteristics, which may be advantageously used in haptic interface applications, including surface coverage haptic applications.

According to various embodiments, the method may further include the steps of providing n additional electroactive layers on the substrate and n additional electrode layers on the substrate, wherein n is an integer equal or greater than 0 (n=0 means there are no additional layers, i.e. single-layer actuator configuration). These steps may be carried out after the step of providing the top electrode. Such structures may also be referred to as stacked structures.

According to various embodiments, when provided, each odd numbered additional electrode layer of the n additional electrode layers may include a respective additional bottom electrical contact portion electrically coupled to the bottom electrical contact portion.

According to various embodiments, when provided, each even numbered additional electrode layer of the n additional electrode layers includes a respective additional top electrical contact portion electrically coupled to the top electrical contact portion.

According to various embodiments, the method may further include forming n additional patterned areas of the protection cover layer. For example, wherein the sum of the patterned areas and the additional patterned areas of the protection cover layer is n+3, for a haptic interface including (n+1) electroactive layers. Further, the step of providing the n additional electrode layers on the substrate may include for at least one of the n additional electrode layers: removing the protection cover layer from the respective additional patterned area of the n additional patterned areas, thereby patterning the additional electrode layer into an additional electrode pattern layer.

According to various embodiments, at least one electrode layer of (i) the bottom electrode layer and (ii) the odd numbered additional electrode layers may include a plurality of bottom strips. The term "electrode layer" in the foregoing sentence may refer to any of the bottom electrode layer and the odd numbered additional electrode layers. For example, the bottom electrode layer may be implemented as bottom strips.

According to various embodiments, at least one electrode layer of (i) the top electrode layer and (ii) the even numbered additional electrode layers may include a plurality of top strips. The term "electrode layer" in the foregoing sentence may refer to any of the top electrode layer and the even numbered additional electrode layers. For example, the top electrode layer may be implemented as top strips.

According to various embodiments, the bottom strips of the plurality of bottom strips may be electrically isolated from each other.

According to various embodiments, the top strips of the plurality of top strips may be electrically isolated from each other.

According to various embodiments, the top strips may be in orthogonal arrangement in relation to bottom strips.

According to various embodiments, the substrate may be a flexible substrate. The substrate may include at least one of, or may be selected from: polyethylene terephthalate (PET), polyethylene naphthalate (PEN), polyimide (PI), polyethyerimide (PEI), polycarbonate (PC), polyether ether ketone (PEEK), polyethersulfone (PES) as well as flexible ultrathin glass, for example with thickness range of 20 to 100 micrometer.

According to various embodiments, the substrate may include a protection cover layer, for example, the substrate may be provided including the protection cover layer. For example, the protection cover layer may be a protective cover film used on commercial flexible substrate for protection of the surface of the substrate, e.g. against scratching or dust. Alternatively, the method may include the step of providing a protection cover layer on the substrate. The protection cover layer may be, for example, a film disposed on the substrate, for example by means of a thin acrylic adhesive layer which may be coated on one side of the film. The protection cover layer may be, for example a Polyethylene (PE) layer, which may be in the form of a film as described above. Exemplary thicknesses for the protection cover layer may be selected from the range of 25 micrometer to 50 micrometer. A PE film with the thickness range of 25 to 50 micrometer, may be used as protection cover layer due to its good thermal and chemical resistance.

According to various embodiments, a thickness of the protection cover layer may be lesser than a thickness of the substrate.

According to various embodiments, a material composition of the protection cover layer may be different from a material composition of the substrate.

According to various embodiments, providing the cut lines may be carried out by laser cutting the protection cover layer, for example by a conventional CO₂ laser cutting machine. The skilled person in the art would understand that the conventional parameters may need to be adjusted for providing the desired cut lines with laser cutting. For example, the dimension of laser cut lines and patterns can be precisely controlled and easily tailored via: i) selecting proper power of a laser source; ii) selecting a proper high power density focusing optic lens, iii) controlling laser intensity, speed, resolution during the laser cutting process.

According to various embodiments, providing a layer may refer to depositing a layer, for example with coating.

According to various embodiments, depositing the bottom electrode layer on the substrate and on the protection cover layer may include to cover at least partially the protection cover layer with the bottom electrode layer and may include to cover at least partially the exposed first portion of the substrate with the bottom electrode layer. According to various embodiments, depositing the top electrode layer on the substrate and on the electroactive layer may include to cover at least partially the electroactive layer with the top electrode layer and may include to cover at least partially a remaining portion of the substrate which is not covered by the electroactive layer with the top electrode layer.

According to various embodiments, depositing an additional electrode layer on the substrate and on any additional electroactive layer may include to cover at least partially the additional electroactive layer with the additional electrode layer and may include to cover at least partially a remaining portion of the substrate which is not covered by the electroactive layer with the additional electrode layer.

According to various embodiments, depositing an electroactive layer (additional electroactive layer) on the substrate and on the top electrode layer (any additional electrode layer) may include to cover at least partially the top electrode layer (any additional electrode layer) with the electroactive layer (additional electroactive layer) and may include to cover a remaining portion of the substrate which is not covered by the top electrode layer (respective additional electrode layer) with the electroactive layer (additional electroactive layer).

According to various embodiments, the expression "at least partially" may mean for example in part or completely.

According to various embodiments the expression "additional electrode layer" may refer to an, any, or each additional electrode layer of the n additional electrode layers, similarly the plural "additional electrode layers" may refer to some or all n additional electrode layers. For example any additional electrode layer refers to any additional electrode layer of the n additional electrode layers.

According to various embodiments the expression "additional electroactive layer" may refer to an, any, or each electroactive layer of the n additional electroactive layers, similarly the plural "additional electroactive layers" may refer to some or all n additional electroactive layers. For example any additional electroactive layer refers to any additional electroactive layer of the n additional electroactive layers.

According to various embodiments, the expression "removing a patterned area" may mean removing the protection cover layer from the first patterned area, in this context removing the protection cover layer means removing the respective portion. For example, removing the first patterned area means removing the protection cover layer from the first patterned area.

According to various embodiments, the bottom electrode layer may be provided by known coating techniques, for example bar coating, spray coating, screen printing, gravure printing, ink jet, slot die and spin coating. The bottom electrode layer may be a transparent layer. The bottom electrode layer may include a transparent material, for example silver nanowires (AgNWs), poly(3,4-ethylenedioxythiophene) polystyrene sulfonate (PEDOT:PSS) or any other transparent electrode material.

Prior the depositing of the bottom electrode layer, a surface treatment may be applied on the substrate. The surface treatment may enhance the adhesion and bonding properties between the bottom electrode and substrate. In one example plasma treatment (such as O₂, or Ar) may be provided. In another example other surface roughening processes to induce hydroxyl (-OH) groups on the surface through surface modification may be provided. In yet another example, the application of an interfacial overcoat layer may be provided. The induced hydrophilicity may also help in better binding between hydrophilic bottom electrode layers (e.g. bar or spray coated AgNWs or PEDOT:PSS) and substrate materials (e.g. PET, PEN, etc.).

According to various embodiments, the top electrode layer may be deposited on a substrate, for example at least partially on an electroactive layer (the electroactive layer or any additional electroactive layer of the n additional electroactive layers). The top electrode layer may be provided by known coating techniques, for example bar coating, spray coating, screen printing, gravure printing, ink jet, slot die and spin coating. The top electrode layer may be patterned by removing the protection cover layer from a respective patterned area. Alternatively or in addition, the top electrode layer may be coated through the use of a shadow mask including opening(s), thus directly providing a pattern on coating, the pattern corresponding to the opening(s). The shadow mask may be prepared, for example, by laser cutting a thin rigid sheet, for example label paper. The shadow mask may be positioned in relation to the substrate, for example by placing the shadow mask on top of the substrate, e.g. on top of the underneath electroactive layer (or additional electroactive layer). According to various embodiments, the top electrode layer may be a transparent layer. According to various embodiments, the top electrode layer may include a transparent electrode material, for example silver nanowires (AgNWs), poly(3,4-ethylenedioxythiophene) polystyrene sulfonate (PEDOT:PSS) or any other transparent electrode material.

Prior the depositing of the top electrode layer, a surface treatment may be applied on the underlying layer, for example the top most layer of electroactive material on the substrate (the electro active layer or additional electroactive layer). The surface treatment may enhance the adhesion and bonding properties between the electroactive layer and the top electrode. In one example plasma treatment (such as O₂, or Ar) may be provided. In another example other surface roughening processes to induce hydroxyl (-OH) groups on the surface through surface modification may be provided. In yet another example, the application of an interfacial overcoat layer may be provided. The induced hydrophilicity may also help in better binding between hydrophilic top electrode layer (e.g. bar or spray coated AgNWs or PEDOT:PSS) and electroactive layer (e.g. FerroEAP).

The disclosure of how to coat the top electrode layer may also apply to any additional electrode layer of the n additional electroactive layers. For example by replacing "top electrode layer" by "any additional electrode layer of the n additional electroactive layers" in the above two paragraphs. The pattern for each additional electrode layer may be different, for example for providing the additional bottom and top electrical contact portions as explained above. Also a same or a different coating method may be used for providing each of the top electrode layer and each additional electrode layer.

According to various embodiments, the electroactive layer may be provided by known thin film processing techniques, for example conventional coating techniques such as, for example, automatic film applicator (doctor blade), bar coating, screen printing, slot die coating, spin coating, roll to roll (R2R) coating. The top electrode layer may be a transparent layer. The electroactive layer may include FerroEAP.

According to various embodiments, the step of providing the electroactive layer may include depositing a layer including an electroactive polymer and post-processing the layer. Post-processing may be used to improve certain properties. Post-processing may include drying and/or annealing. For example, for FerroEAP layer, drying and annealing may improve the crystalline structure and ferroelectric properties of a coated FerroEAP layer.

The disclosure of how to coat the electroactive layer may also apply to any additional electroactive layer. For example by replacing "electroactive layer" by "any additional electroactive layer of the n additional electroactive layers" in the above two paragraphs.

According to various embodiments, the processes of depositing or coating as explained above may be applied multiple times, for example for producing stacked structures.

According to various embodiments, any remaining protection cover layer may be removed, for example after the deposition the top electrode or the last additional top electrode, if provided.

The method according to various embodiments offers the following advantages: high compatibility with standard thin film coating process, e.g. doctor blade film application; no special patterning masks required for complex array design and multi-layered structure fabrication, for example by utilizing a protective cover film on commercial flexible substrate as temporary masks, and providing cut lines in the same; flexibility in producing various haptic actuator designs and haptic interfaces (e.g. complex array or multi-stacked structures) and up-scaling; provide significant time and cost savings especially during initial prototyping or development stage of devices where multiple design iterations are required.

According to various embodiments, the expression "removing the protection cover layer" used in conjunction with a patterned area may mean removing a portion of the protection cover layer, which portion covers the patterned area. Thus, after removing the protection cover layer in a certain patterned area, other areas, such as other patterned areas, may still be covered by the protection cover layer. For example "removing the protection cover layer from the first patterned area" means removing a portion of the protection cover layer which covers the first patterned area.

According to various embodiments, the electroactive layer or any or all of the n additional electroactive layers may include a ferroelectric polymer. Ferroelectric polymer (FerroEAP) may provide vibrational haptic feedback, for example for flexible touch screen application, by applying an electrical stimulus to the respective top and bottom electrode layers. FerroEAP materials here referring to poly(vinylidene fluoride) (PVDF), PVDF copolymers or PVDF terpolymers. Ferroelectric polymers offer several advantages such as flexible form factor, ease of processability, fast electromechanical response, and high mechanical and chemical stability. In particular, FerroEAP can be easily adopted for realization of whole and localized vibrational haptic feedback on touch sensitive surfaces to impart physical response on user fingers upon interaction.

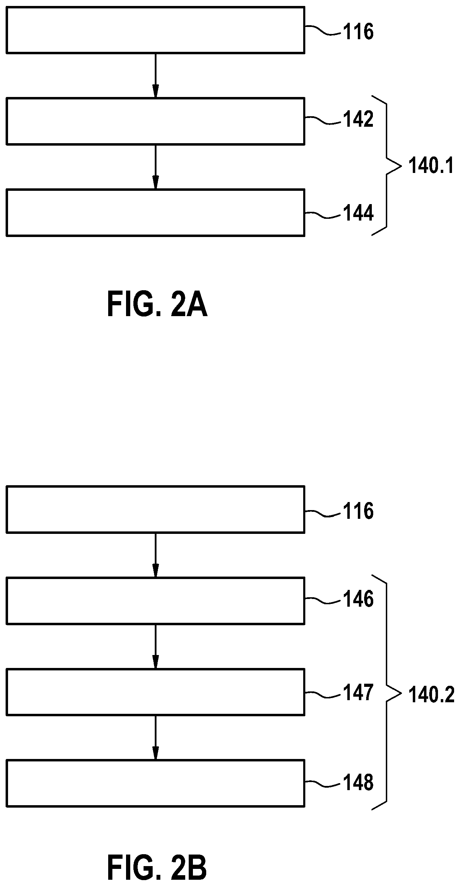

The top electrode layer may be provided by different methods according to various embodiments. Step 140 may be carried out as step 140.1 or as step 140.2, according to various embodiments. These different methods will be explained in conjunction with FIG. 2A and FIG. 2B.

In accordance to some embodiments, and as illustrated for exemplary purposes in FIG. 2A, the method 100 of FIG. 1, may further include the step 116 of forming a top electrode layer patterned area of the protection cover layer for defining the top electrode layer which may include the area for the top electrode and may further include the top electrical contact portion. For example, step 116 may be included as sub-step of method step 115. Thus, the step 115 of providing cut lines in the protection cover layer may further include forming a top electrode layer patterned area which may include the area for the top electrode and may include the top electrical contact portion.

Step 140 may be carried out as step 140.1. The step 140.1 of providing the top electrode layer may include step 142 of removing the protection cover layer from the top electrode layer patterned area, and may further include step 144 of depositing the top electrode layer on the substrate and on the electroactive layer, thereby patterning the top electrode layer into the top electrode layer pattern which may include the area for the top electrode and the top electrical contact portion.

In accordance to some embodiments, and as illustrated for exemplary purposes in FIG. 2B, step 140 of method 100 of FIG. 1 may be carried out as step 140.2. Step 140.2 of providing the top electrode layer may include step 146 of positioning a shadow mask on the substrate, and may further include step 147 of depositing the top electrode layer via a shadow mask wherein the top electrode layer pattern may be defined by distancing the shadow mask at step 148.

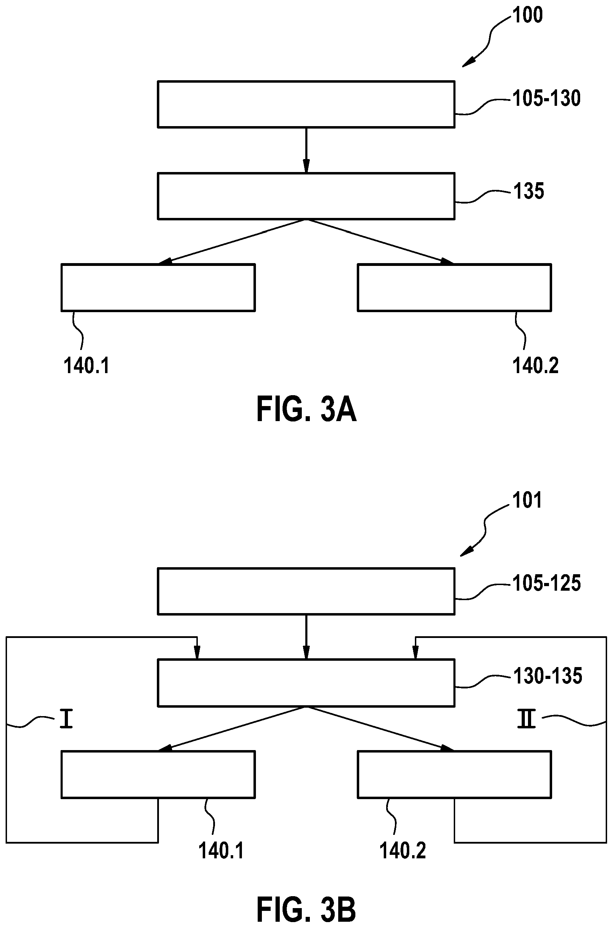

FIG. 3A shows a flow chart of a method 100, for producing a patterned layer structure, in accordance to various embodiments, wherein the top electrode layer may be provided according to method 140.1 or 140.2. For example, as illustrated in FIG. 3A, firstly, method steps 105 to 130 are carried out succeeded by method step 135. After method step 135 of depositing an electroactive layer on the substrate and on the bottom electrode layer, the step 140 of providing a top electrode layer including a top electrode layer pattern including a top electrical contact portion may be carried out as step 140.1 or 140.2. Other step modifications may be possible, for example for step 140.1, step 116 of forming a top electrode layer patterned area of the protection cover layer, for defining the top electrode layer which may include the area for the top electrode and may further include the top electrical contact portion, may have been carried out in advance, before carrying out step 140.1. After providing the top electrode, for example with steps 140.1 or 140.2, other method steps may be provided. For example, the method 100 may include, after step 140.1, removing a remaining portion of the protection cover layer 261, wherein the remaining portion of the protection cover layer may be all of the remaining cover layer, as step 170.

According to various embodiments, the method may further include additional methods steps for providing n additional electroactive layers and n additional electrode layers, wherein n is an integer equal or greater than 0 (n=0 means there are no additional layers, i.e. single-layer actuator configuration). For example, the integer n may be selected from: 1, 2, 3, 4, 5, 6, 7, 8, 9, or 10 for achieving a sufficient haptic feedback force. The step of providing an additional electroactive layer may be provided, e.g., by repeating step 130 for the (n+2)th patterned area instead, and step 135, of depositing an electroactive layer on the substrate and on the top electrode layer (instead the bottom electrode layer). The step of providing an additional electrode layer may be provided, e.g., by repeating step 140, by providing an additional electrode layer (instead the top electrode layer) including an additional electrode layer pattern including an additional electrode layer contact portion. The electrically coupling of multiple single actuators in parallel, which in a stacked structure provides the advantages that the mechanical intensity of the haptic actuators are added.

FIG. 3B shows a flow chart for illustrating a method 101, for producing a patterned layer structure in accordance to various embodiments. Method 101 may be identical to method 100, further including additional methods steps for providing n additional electroactive layers and n additional electrode layers, wherein n is an integer equal or greater than 0 (n=0 means there are no additional layers, i.e. single-layer actuator configuration), as explained above. For example, the integer n may be selected from: 1, 2, 3, 4, 5, 6, 7, 8, 9, or 10 for achieving a sufficient haptic feedback force.

In the illustrated method of FIG. 3B, after providing the top electrode layer, for example with a step 140.1, steps 130, 135 and 140 (140.1 or 140.2) may be repeated n times for providing n additional electroactive layers and n additional electrode layers. In each of the n iterations, path I or II may be chosen, for example in all iterations path I may be chosen, in another example, all iterations may choose path II. As previously explained, for providing the n additional electroactive layers and n additional electrode layers, the steps 130, 135 and 140 (140.1 or 140.2) may be adapted accordingly, i.e. in step 130 the protection cover layer is removed from the (n+2)th patterned area, in step 135 an additional electroactive layer is provided instead of the electroactive layer, and in step 140 (140.1 or 140.2), an additional electrode layer is provided instead of the top electrode layer. After providing the (n+2)th electrode, for example with steps 140.1 or 140.2, other method steps may be provided. For example, the method 101 for a (n+1)-layer haptic feedback interface may include, after step 140, removing a remaining portion of the protection cover layer as step 170.

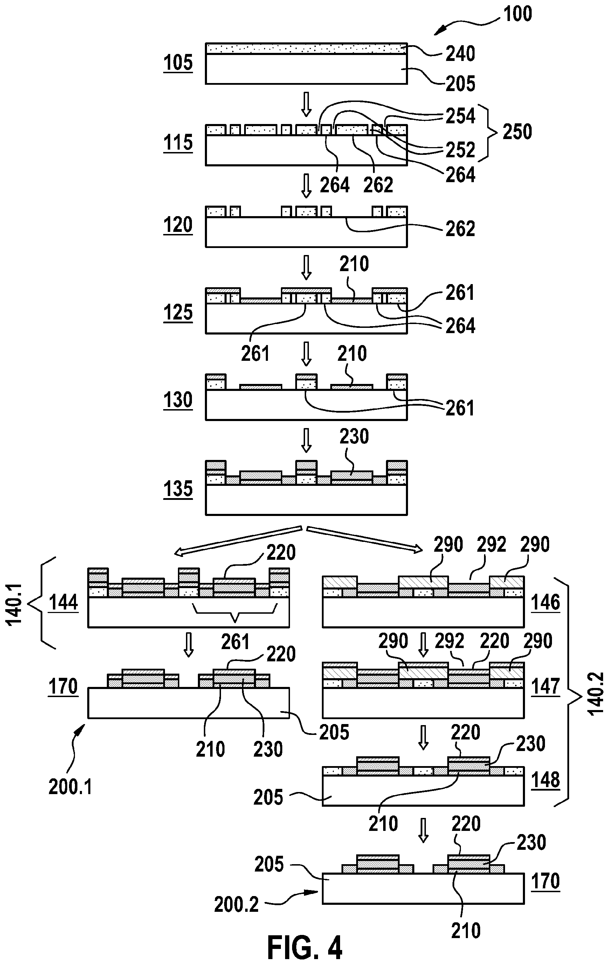

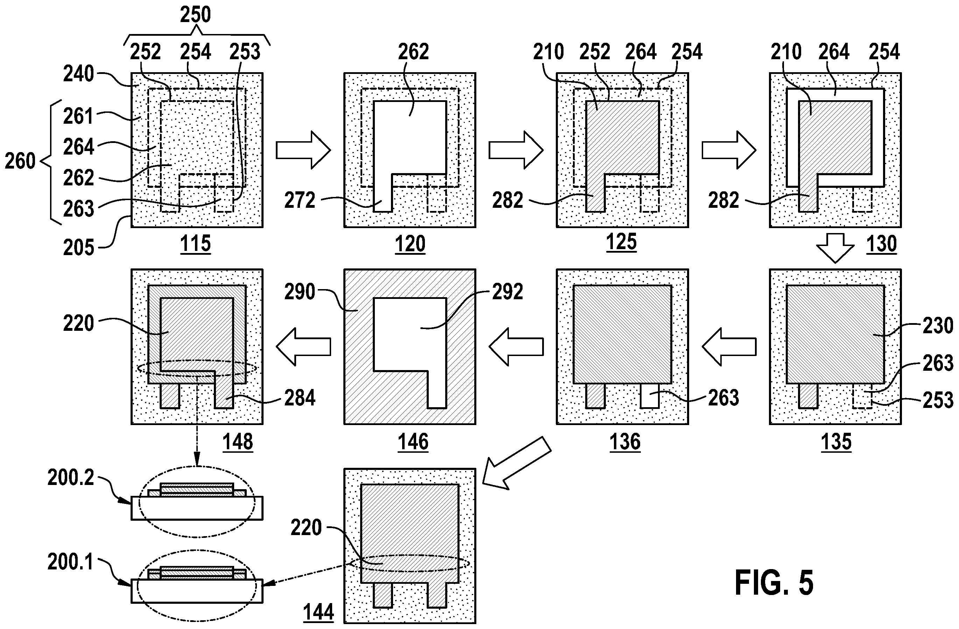

FIG. 4 shows a schematic cross sectional view of the patterned layer structure during the various method steps, in accordance to various embodiments. An exemplary schematic top view of the patterned layer structure during the various method steps is illustrated in FIG. 5. FIG.5 is limited to the top view of a patterned layer structure formed by a single the overlap of layers 210, 230, 220. FIG. 4 shows steps for producing two patterned haptic interface e.g. 2 x 1 array configuration, resulting from two overlapped areas of layers 210, 230, 220. The following explanation for FIG. 4 may be accompanied in conjunction with FIG. 5 for easy of reference. It is however to be understood that differences may apply, for example features of the embodiments of FIG. 4 may apply to the embodiment of FIG. 5 or vice-versa. Also features of one embodiment may not necessarily restrict the other embodiment.

Turning to FIG. 4, is it shown that the method 100 may include the step of providing a substrate 205 and a protection cover layer (240) disposed on the substrate 205. In one example, the method 100 may further include the step (not shown) of disposing the protection cover layer 240 on the substrate 205. The method 100 may further include the step 115 of providing cut lines 250 in the protection cover layer 240 thereby forming a first patterned area 262 and a second patterned area 264 of the protection cover layer 240. The method 100 may further include the step 120 of removing the first patterned area 262 of the protection cover layer 240, thus exposing a portion of the substrate 205 corresponding to the first patterned area 262. The method 100 may further include the step 125 of depositing a bottom electrode layer 210 on the substrate 205 (e.g., on the portion(s) of the substrate 205 corresponding to the first patterned area 262) and on the protection cover layer 240 (e.g., on the second patterned area 264 of the protection cover layer 240). The method 100 may further include the step 130 of removing the second patterned area 264 of the protection cover layer 240 (with the bottom electrode layer on top) so as to expose the substrate 205, thereby patterning the bottom electrode layer 210 and thus providing a bottom electrode layer pattern including a bottom electrical contact portion 282. The method 100 may further include the step 135 of depositing an electroactive layer 230 on the substrate 205 (e.g., on the exposed portion(s) of the substrate 205 corresponding to the second patterned area 264) and on the patterned bottom electrode layer 210. The method 100 may further include the step 140 (140.1 or 140.2) of providing a top electrode layer 220 including a top electrode layer pattern including a top electrical contact portion 284. The top electrode layer 220 may be provided for example by step 140.1 or by step 140.2.

The step 140.1 of providing the top electrode layer 220 may include step 142 of removing the protection cover layer from the top electrode layer patterned area (not shown) and/or 144 of depositing the top electrode layer 220 which may include the top electrical contact portion 284 on the substrate 205 and on the electroactive layer 230. After step 140.1, the step 170 of removing a remaining portion 261 of the protection cover layer 240 may be carried out, thereby patterning the top electrode layer 220 into the top electrode layer pattern as well as completing a single-layer haptic interface.

When step 140.1 is used for providing the top electrode layer 220, the method 100 may further include a step of forming the top electrical contact portion area (not shown in FIG.4 but shown in FIG.5 as 263). For example, the method 100 may include a step 116 of forming a top electrical contact portion area 263 of the protection cover layer 240. For example, step 116 may be included as sub-step of method step 115. Thus, the step 115 of providing cut lines 250 in the protection cover layer 240 may further include forming a top electrical contact portion area 263.

It can be seen in FIG. 4, that in step 170, a patterned layer structure 200.1 is produced including a substrate 205, a bottom electrode layer 210 including a bottom electrode layer pattern, a top electrode layer 220 including a top electrode layer pattern and an electroactive layer 230, including an electroactive layer pattern, the electroactive layer 230 disposed between the bottom electrode layer 210 and the top electrode layer 220. A top electrical contact portion (not shown in FIG. 4) and a bottom electrical contact portion (not shown in FIG. 4) may also be provided.

The step 140.2 of providing the top electrode layer 220 may include the step 146 of preparing and/or positioning a shadow mask 290 in relation to the substrate, for example positioning the shadow mask 290 on the substrate. The step 140.2 may further include the step 146 of positioning a shadow mask 290 on the substrate, and may further include step 147 of depositing the top electrode layer 220 via the shadow mask 290.The top electrode layer pattern is defined by the shadow mask 290, specifically by opening(s) 292 of the shadow mask 290. The step 140.2 may further include the step 148 of distancing the shadow mask 290 in relation to the substrate 205, for example removing the shadow mask 290. It can be seen in FIG. 4, that in step 147, a patterned layer structure 200.2 is produced including a bottom electrode layer 210 including a bottom electrode layer pattern, a top electrode layer 220 including a top electrode layer pattern and an electroactive layer 230, including an electroactive layer pattern, the electroactive layer 230 disposed between the bottom electrode layer 210 and the top electrode layer 220. A top electrical contact portion (not shown in FIG.4) and a bottom electrical contact portion (not shown in FIG.4) may also be provided. After providing the top electrode, for example with steps 140.2 (including step 146, 147 and 148), other method steps may be provided. For example, the method 100 may include, after step 140.2, removing a remaining portion of the protection cover layer 261 as step 170.

FIG. 5, shows a schematic top view of the patterned layer structure during the various method steps, in accordance to various embodiments. It is shown that the method 100 may include the step of providing a substrate 205. The substrate 205 may include a protection cover layer 240. For example, the method 100 may include the step (not shown) of providing a protection cover layer 240 on the substrate 205. The method 100 may further include the step 115 of providing cut lines 250 in the protection cover layer 240 thereby forming a first patterned area 262 and a second patterned area 264. For example cut line 252 may delimit a first patterned area 262, and cut line 254 may delimit a second patterned area 264. The method 100 may further include the step 120 of removing the protection cover layer from the first patterned area 262, thus exposing the substrate at the first patterned area 262. The method 100 may further include the step 125 of depositing a bottom electrode layer 210 on the substrate 205 and on the protection cover layer 240. The method 100 may further include the step 130 of removing the protection cover layer 240 from the second patterned area 264, thereby patterning the bottom electrode layer 210 providing a bottom electrode layer pattern including a bottom electrical contact portion 282.

As shown in FIG. 5, the cut line 252 may define an area 272, this area 272 may be part of the patterned area 262 (as shown), alternatively it may be a separate patterned area. As can be seen in step 120, the area 272 for the bottom electrode contact portion may be provided in the same step, for example, together when forming the first patterned area 262. Alternatively, the area 272 for the bottom electrode contact portion may also be provided in a separate step. The area 272 for the bottom electrode contact portion may be an area in which the substrate is exposed, as illustrated in FIG. 5, step 120.

As further illustrated in FIG. 5, the bottom electrode contact portion 282 may be provided together with steps 125 and 130. For example, the bottom electrode layer 210 and the bottom electrode contact portion 282 may be part of a same continuous layer.

The method 100 may further include the step 135 of depositing an electroactive layer 230 on the substrate 205 and on the bottom electrode layer 210.

The method 100 may further include the step 136, wherein an area for the top electrode contact portion is provided by removing the protection cover layer 240 from the patterned area 263. Patterned area 263 may be defined by cut line 253, which may be provided, for example, in step 115.

The method 100 may further include the step of providing a top electrode layer 220 including a top electrode layer pattern including a top electrical contact portion 284. The top electrode layer 220 may be provided for example by steps 146-148 or by step 144.

Providing the top electrode layer 220 may include step 144 of depositing the top electrode layer 220 on the substrate 205 and on the electroactive layer 230, and may further include the step of removing the remaining protection cover layer 261, thereby patterning the top electrode layer 220 into the top electrode layer pattern. An exemplary resulting patterned layer structure 200.1 is shown in FIG. 5.

Alternatively, providing the top electrode layer 220 may include steps 146-148. Accordingly, providing the top electrode layer 220 may include the step 146 of positioning a shadow mask 290 in relation to the substrate, for example positioning the shadow mask 290 on the substrate. FIG. 5 shows, as an example, a shadow mask 290 with an opening 292, wherein the opening defines the top electrode layer pattern. The shadow mask could be provided with a plurality of openings. The opening(s) may be provided with a different pattern than shown. Providing the top electrode layer 220 may include the step of depositing the top electrode layer 220 via the shadow mask 290 wherein the top electrode layer pattern is defined by the shadow mask 290, specifically by the opening(s) 292 of the shadow mask 290. Providing the top electrode layer 220 may include the step 148 of distancing the shadow mask 290 in relation to the substrate 205, for example removing the shadow mask 290. It can be seen in FIG. 5, that a patterned layer structure 200.2 is produced including a bottom electrode layer 210 including a bottom electrode layer pattern, a top electrode layer 220 including a top electrode layer pattern and an electroactive layer 230, including an electroactive layer pattern, the electroactive layer 230 disposed between the bottom electrode layer 210 and the top electrode layer 220.

Providing the top electrode layer 220 may further include providing a top electrical contact portion 284, e.g. together with steps 146-148. For example, the mask may be configured with a shape, for example a shape including an opening. The opening may be configured as a plurality of openings.

In a further step, the remaining cover layer 261 may be removed.

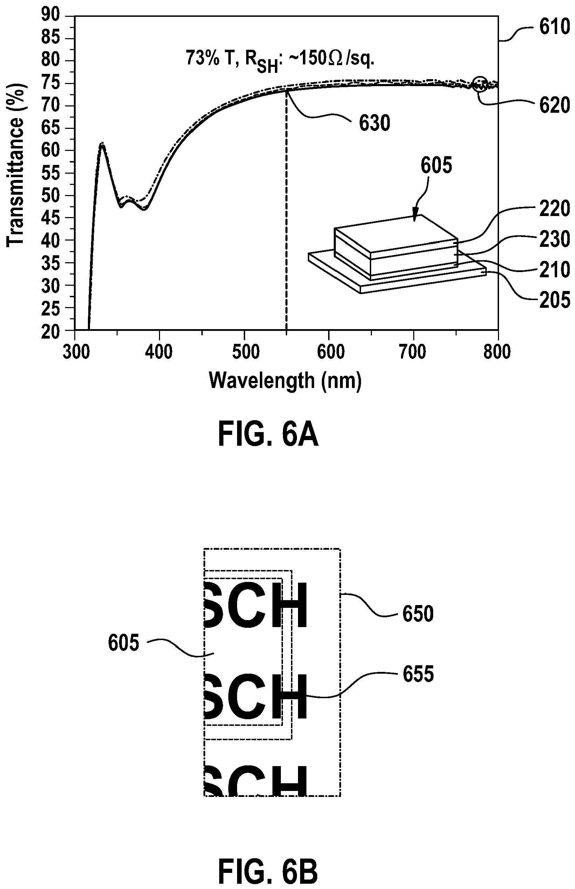

FIG. 6A shows is an exemplary graph 610 showing transmittance spectra 620 taken of a patterned layer structure 605 as schematically shown in the inset and according to various embodiments. At point 630, of wavelength 550 nm, the transmittance value is 73%, and the sheet resistance is about 150 ohm-square. The inset shows the patterned layer structure 605 including a transparent substrate 205, and a transparent electroactive layer 230 between a transparent bottom electrode layer 210 and a transparent top electrode layer 220. The patterned layer structure 605 is a functional actuator produced with the method in accordance to various embodiments, it showed a high optical transparency with clear perceivable haptic vibrational feedback.

FIG. 6B shows a line drawing representation of a photograph taken of the patterned layer structure 605 against a white background 650 on which the letters "SCH" 655 are printed in a dark color.

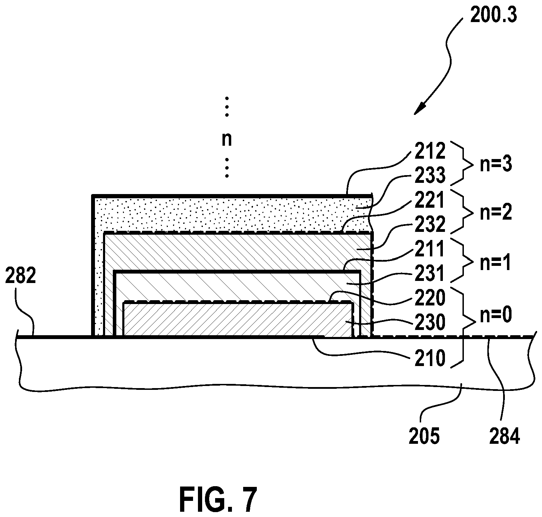

FIG. 7 shows a schematic cross sectional view illustrating a patterned layer structure including n additional electroactive layers and n additional electrode layers, in accordance to various embodiments. FIG. 7 shows a bottom electrode layer 210 on the substrate 205, an electroactive layer 230 on the substrate 205 and at least partially covering the bottom electrode layer 210, a top electrode layer 220 on the substrate 205 and at least partially covering the electroactive layer 230.

FIG. 7 further shows an additional electroactive layer 231 (n=1, 1 additional electroactive layer, for preparation of a 2-layer haptic interface) provided on the substrate and at least partially covering the electrode layer 220. It is further shown an additional electrode layer 211 (n=1, 1 additional electrode layer, for preparation of a 2-layer haptic interface) on the substrate and at least partially covering the additional electroactive layer 231.

FIG. 7 further shows an additional electroactive layer 232 (n=2, 2 additional electroactive layers, for preparation of a 3-layer haptic interface) provided on the substrate and at least partially covering the additional electrode layer 211. It is further shown an additional electrode layer 221 (n=2, 2 additional electrode layers, for preparation of a 3-layer haptic interface) on the substrate and at least partially covering the additional electroactive layer 232.

Further additional electrode layers (n=3, 4, ...) and further additional electroactive layers (n=3, 4, ...) may be provided. FIG. 7 shows that the additional electrode layers wherein n is an odd number may be electrically coupled to each other and to the bottom electrode layer, for example including a common bottom electrical contact portion 282. FIG. 7 shows that the additional electrode layers wherein n is an even number may be electrically coupled to each other and to the top electrode layer, for example including a common top electrical contact portion 284.

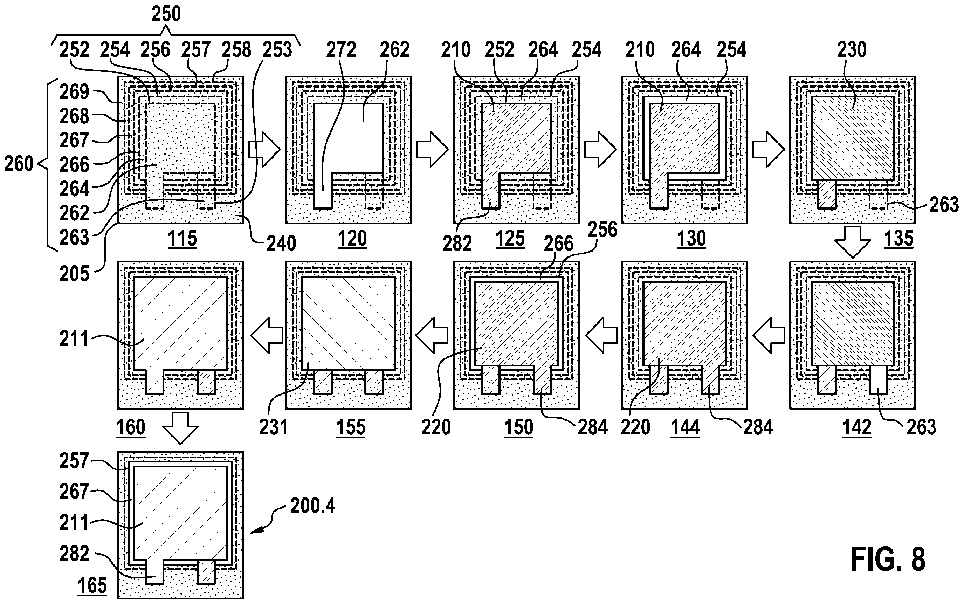

FIG. 8 shows a schematic top view of the patterned layer structure including n additional electroactive layers and n additional electrode layers, during the various method steps, in accordance to various embodiments. The steps 115 to 144 may be identical to the steps explained in conjunction with FIG. 5, except that additional cut lines 256, 257, 258 and respectively, additional patterned areas 266, 267, 268, 269 may be provided in step 115.

FIG. 8 shows that the method according to various embodiments, may further include the step 150 of removing the protection cover 240 from the third patterned area 266, thereby patterning the top electrode layer 220 into the top electrode layer pattern. Patterned area 266 may be defined by cut line 256, which may be provided, for example, in step 115.

FIG. 8 shows that the method according to various embodiments, may further include the step 155 of providing an additional electroactive layer 231 (n=1) on the substrate 205 and at least partially covering the top electrode layer 220.

FIG. 8 shows that the method according to various embodiments, may further include the step 160 of depositing an additional electrode layer 211 (n=1) on the substrate 205 and on the additional electroactive layer 231. As can be seen in FIG. 7, since n=1 is odd, the additional electrode layer 211 for a 2-layer haptic interface may be electrically coupled to the bottom electrode layer 210, for example, at the common bottom electrical contact portion 282.

FIG. 8 shows that the method according to various embodiments, may further include the step 165 of removing the protection cover 240 from the patterned area 267. This step may, for example, provide patterning additional electroactive layer 231 (n=1) into an additional electroactive layer and electrode pattern. Patterned area 267 may be defined by cut line 257, which may be provided, for example, in step 115.

Further additional electrode layers (n=2, 3, 4, ...) and further additional electroactive layers (n=2, 3, 4, ...) may be provided, for example by repeating the process steps 150 to 160.

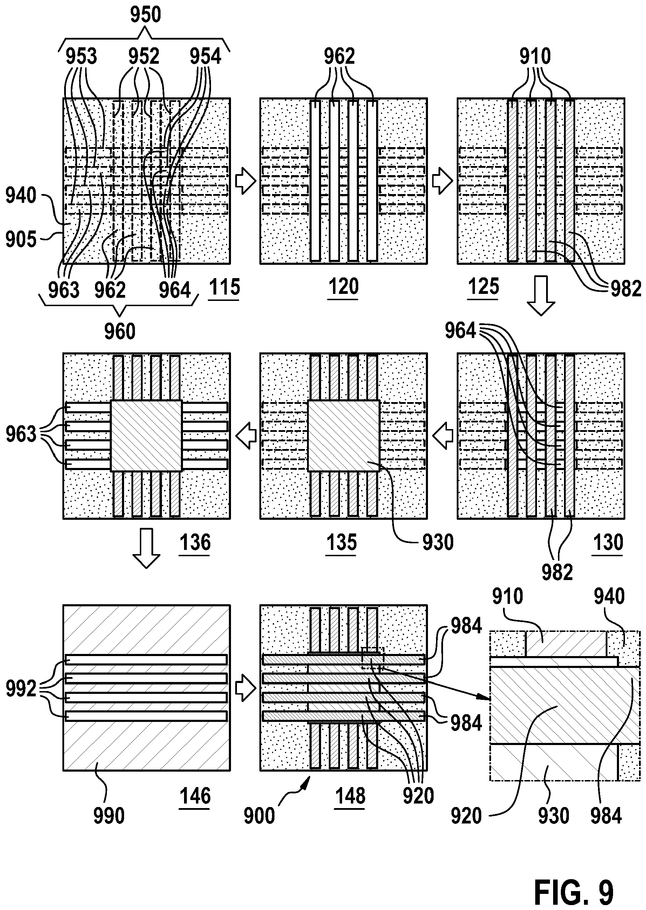

FIG. 9 shows a schematic top view of a patterned layer structure wherein top strips 920 are in orthogonal arrangement in relation to bottom strips 910 and the method steps for providing such structure. The method may include the step of providing a substrate 905 and a protection cover layer 940 disposed on the substrate 905. In one example, the method may further include the step (not shown) of disposing the protection cover layer 940 on the substrate 905. The method may further include the step 115 of providing cut lines 950 in the protection cover layer 940 thereby forming patterned areas 960. For example cut lines 952 may delimit a first patterned area 962, which may be subdivided into a plurality of strips. For example cut lines 954 may delimit a second patterned area 964, which may be subdivided into a plurality of strips. The method may further include the step 120 of removing the first patterned area 962 of the protection cover layer 940, thus exposing a portion of the substrate corresponding to the first patterned area 962. The method may further include the step 125 of depositing a bottom electrode layer 910 on the exposed portion of the substrate 905 and on the (remaining portion(s)) of the protection cover layer 940 (e.g., on the second patterned area of the protection cover layer). The method may further include the step 130 of removing the second patterned area of the protection cover layer 940 and the bottom electrode layer disposed on top of the second patterned area 964, thereby patterning the bottom electrode layer 910 so as to provide a bottom electrode layer pattern including a bottom electrical contact portion 982, which is illustratively shown on one end of the strips, but is not limited thereto. The bottom electrode layer may include a plurality of bottom strips, as illustrated in FIG. 9. The method may further include the step 135 of depositing an electroactive layer 930 on the substrate 905 and on the bottom electrode layer 910. The method may further include the step 136, wherein an area for the top electrode contact portion is provided by removing the protection cover layer 940 from the patterned area 963. Patterned area 963 may be defined by cut line 953, which may be provided, for example, in step 115 and 116.

As illustrated in FIG. 9, the method may further include the step of providing a top electrode layer 920 including a top electrode layer pattern including a top electrical contact portion. As previously explained, the top electrode layer may be provided by different methods according to various embodiments. For illustrative purposes, a mask deposition method will be shown in FIG. 9. Thus, providing the top electrode layer 920 may include steps 146-148. Accordingly, providing the top electrode layer 920 may include the step 146 of positioning a shadow mask 990 in relation to the substrate, for example positioning the shadow mask 920 on the substrate. FIG. 9 shows, as an example, a shadow mask 990 with a plurality of openings 992, wherein the opening defines the top electrode layer pattern. The openings 992 may be provided with a pattern of strips, as shown. Providing the top electrode layer 920 may include the step of depositing the top electrode layer 920 via the shadow mask 990 wherein the top electrode layer pattern is defined by the shadow mask 990, specifically by the openings 992. The top electrode layer may include a plurality of top strips, as illustrated in FIG. 9. Providing the top electrode layer 920 may include the step 148 of distancing the shadow mask 990 in relation to the substrate 905, for example removing the shadow mask 990, thereby patterning the top electrode layer 920 so as to provide a top electrode layer pattern including a top electrical contact portion 984, which is illustratively shown on one end of the strips, but is not limited thereto. The resulting patterned structure includes top strips in orthogonal arrangement in relation to the bottom strips such that overlapping areas are formed, and wherein the overlapping areas are arranged as a matrix. Thus providing a matrix of a plurality of actuators.

The lower right corner of FIG.9 shows a magnified portion, wherein layers 910, 930 and 920 overlap.

According to various embodiments, each individually electrically assessable area of the patterned layer structure may be considered an actuator.

According to various embodiments, the patterned layer structure may be substantially transparent. For example, the actuator areas may be transparent.

According to various embodiments, each of the substrate, the bottom electrode layer, the top electrode layer, the electroactive layer and, if provided, each of the n additional electroactive layers and each of the n additional electrode layers, may be transparent.

According to various embodiments a haptic interface may be provided. A haptic interface may include a patterned layer structure according to various embodiments, for example including a plurality of actuators. The plurality of actuators may be arranged according to a pre-defined pattern, for example a matrix structure as shown in FIG. 9. The interface may be, for example, a keyboard, part of a touch screen, or part of a display. For example a display may include the interface. In another example, a touch screen may include the interface.

## Claims

1. A method (100), for producing a patterned layer structure (200.1, 200.2, 200.3, 200.4, 900), for a haptic interface, the method (100) comprising the steps of:
- providing a substrate (205, 905) and a protection cover layer (240, 940) disposed on the substrate (205, 905);
- providing cut lines (250, 950) in the protection cover layer (240, 940), thereby forming a first patterned area (262, 962) and a second patterned area (264, 964) of the protection cover layer (240, 940);
- removing the first patterned area (262, 962) of the protection cover layer (240, 940) so as to expose a first portion (262, 292) of the substrate (205, 905);
- depositing a bottom electrode layer (210, 910) on the exposed first portion (262, 292) of the substrate (205, 905) and on the second patterned area (264, 964) of the protection cover layer (240, 940);
- removing the second patterned area (264, 964) of the protection cover layer (240, 940) and the bottom electrode layer on the second patterned area (264, 964) so as to expose a second portion (264, 964) of the substrate (205, 905), thereby patterning the bottom electrode layer (210, 910) so as to form a bottom electrode layer pattern comprising a bottom electrical contact portion (282, 982);
- depositing an electroactive layer (230, 930) on the exposed second portion (264, 964) of the substrate (205, 905) and on the patterned bottom electrode layer (210, 910);
- providing a top electrode layer (220, 920) comprising a top electrode layer pattern comprising a top electrical contact portion (284, 984).

2. The method (100) of claim 1, further comprising
providing n additional electroactive layers (231, 232, 233) on the substrate (205) and n additional electrode layers (211, 221, 212) on the substrate (205);
wherein n is an integer equal or greater than 1.

3. The method (100) of claim 2, wherein
when provided, each odd numbered additional electrode layer (211, 212) of the n additional electrode layers (211, 221, 212) comprises a respective additional bottom electrical contact portion electrically coupled to the bottom electrical contact portion (282), and
when provided, each even numbered additional electrode layer (221) of the n additional electrode layers (211, 221, 212) comprises a respective additional top electrical contact portion electrically coupled to the top electrical contact portion (284).

4. The method (100) of any of claims 1 to 3, wherein
providing the top electrode layer (220, 920) comprises depositing the top electrode layer via a shadow mask (290, 990) wherein the top electrode layer pattern is defined by the shadow mask (290, 990).

5. The method (100) of any of claims 1 to 4, wherein
providing cut lines (250, 950) in the protection cover layer (240, 940) further comprises forming a top electrical contact portion area and/or a remaining cover layer (261).

6. The method (100) of claim 5, wherein
providing the top electrode layer (220) comprises:
depositing the top electrode layer (220) on the substrate and on the electroactive layer (230);
removing the top electrical contact portion area and/or the remaining cover layer (261) from the protection cover layer (240), thereby patterning the top electrode layer (220) into the top electrode layer pattern.

7. The method (100) of any of claims 2 to 6, further comprising
forming n additional patterned areas of the protection cover layer (240), and wherein providing the n additional electrode layers on the substrate (205) comprises for at least one of the n additional electrode layers: removing the protection cover layer (240) from the respective additional patterned area of the n additional patterned areas, thereby patterning the additional electrode layer into an additional electrode pattern layer.

8. The method (900) of any of claims 1 to 7, wherein
at least one of the bottom electrode layer (910) and the odd numbered additional electrode layers comprises a plurality of bottom strips.

9. The method (900) of any of claims 1 to 7, wherein
at least one of the top electrode layer (920) and the even numbered additional electrode layers comprises a plurality of top strips.

10. The method (100) of claims 8 and 9, wherein the top strips are in orthogonal arrangement in relation to the bottom strips such that overlapping areas are formed, and wherein overlapping areas are preferably arranged as a matrix.

11. The method (100) of any of claims 1 to 10, wherein providing cut lines (250) is carried out by laser cutting the protection cover layer (240, 940).

12. The method (100) of any of claims 1 to 11, wherein the electroactive layer comprises a ferroelectric polymer and/or wherein each additional electroactive layer comprises a ferroelectric polymer.

13. A patterned layer structure (200.1, 200.2, 200.3, 200.4, 900) for a haptic interface produced by the method according to any of the claims 1 to 12.

14. The patterned layer structure (200.1, 200.2, 200.3, 200.4, 900) of claim 13, wherein each of the substrate (205, 905), the bottom electrode layer (210, 910), the top electrode layer (220, 920), the electroactive layer (230, 930) and, if provided, each of the n additional electroactive layers and each of the n additional electrode layers, are transparent.

15. A haptic interface comprising the patterned layer structure (200.1, 200.2, 200.3, 200.4, 900) according to claim 14 or 15.
